(19) **Europäisches Patentamt / European Patent Office / Office européen des brevets**

(11) **EP 1 210 737 B1**

(12) # EUROPÄISCHE PATENTSCHRIFT

(45) Veröffentlichungstag und Bekanntmachung des Hinweises auf die Patenterteilung:
**27.02.2019   Patentblatt 2019/09**

(21) Anmeldenummer: **00974281.8**

(22) Anmeldetag: **04.09.2000**

(51) Int Cl.:
**H01L 33/00** $^{(2010.01)}$

(86) Internationale Anmeldenummer:
**PCT/DE2000/003027**

(87) Internationale Veröffentlichungsnummer:
**WO 2001/018883 (15.03.2001 Gazette 2001/11)**

(54) **LICHTEMISSIONSDIODE MIT OBERFLÄCHENSTRUKTURIERUNG**

LIGHT-EMITTING DIODE WITH A STRUCTURED SURFACE

DIODE ELECTROLUMINESCENTE A SURFACE STRUCTUREE

(84) Benannte Vertragsstaaten:
**DE FR GB**

(30) Priorität: **10.09.1999   DE 19943406**

(43) Veröffentlichungstag der Anmeldung:
**05.06.2002   Patentblatt 2002/23**

(60) Teilanmeldung:
**10192433.0 / 2 290 714**

(73) Patentinhaber: **OSRAM Opto Semiconductors GmbH
93055 Regensburg (DE)**

(72) Erfinder: **WIRTH, Ralph
93049 Regensburg (DE)**

(74) Vertreter: **Epping - Hermann - Fischer
Patentanwaltsgesellschaft mbH
Schloßschmidstraße 5
80639 München (DE)**

(56) Entgegenhaltungen:
EP-A- 0 405 757     EP-A- 0 732 740
EP-A1- 0 544 512    DE-A- 4 218 806
DE-A- 19 537 544    DE-A- 19 709 228
US-A- 5 162 878     US-A- 6 091 085

• SCHNITZER I ET AL: "30% external quantum efficiency from surface textured LEDs" APPLIED PHYSICS LETTERS, OKT 1993, Bd. 63, Seiten 2174-2176, XP000404433 ISSN: 0003-6951
• WINDISCH R ET AL: "LEDs with 31% external quantum efficiency" APPLIED PHYSICS LETTERS, APRIL 1999, Bd. 74, Seiten 2256-2258, XP002145910 ISSN: 0003-6951

## Beschreibung

Die Erfindung betrifft eine Lichtemissionsdiode mit den Merkmalen des Patentanspruchs 1. Sie betrifft demnach eine Lichtemissionsdiode, bei der die dem Substrat gegenüberliegende Oberfläche zur Verbesserung der Lichtauskopplung auf mindestens einem Abschnitt eine Mehrzahl von Pyramidenstümpfen aufweist.

Lichtemissionsdioden, wie Halbleiter-Leuchtdioden (LED), zeichnen sich insbesondere dadurch aus, daß je nach Materialsystem der interne Umwandlungswirkungsgrad von zugeführter elektrischer Energie in Strahlungsenergie sehr groß, d.h. durchaus größer als 80 % sein kann. Die effektive Lichtauskopplung aus dem Halbleiterkristall wird jedoch durch den hohen Brechungsindexsprung zwischen dem Halbleitermaterial (typischerweise $n = 3,5$) und dem umgebenden Harzguß-Material (typischerweise $n = 1,5$) erschwert. Der sich daraus ergebende kleine Totalreflexionswinkel an der Grenzfläche Halbleiter-Harzvergußmaterial von ca. 26° führt dazu, daß nur ein Bruchteil des erzeugten Lichts ausgekoppelt werden kann. In der typischerweise bei der Herstellung verwendeten einfachen würfelförmigen Gestalt der LED bleibt ein Strahlungsbündel, das nicht in dem ca. 26° weiten Auskoppelkegel emittiert wird, in dem Halbleiterkristall gefangen, da sein Winkel zu den Oberflächennormalen auch durch Vielfachreflexion nicht verändert wird. Das Strahlungsbündel wird infolgedessen früher oder später durch Absorption vor allem im Bereich des Kontakts, der aktiven Zone oder im Substrat verlorengehen. Insbesondere bei InGaAlP-LEDs stellt das absorbierende GaAs-Substrat ein besonderes Problem dar. In konventionellen LEDs dieser Art gehen die von der aktiven Zone in Richtung zur Oberfläche der LED emittierte Strahlen, die außerhalb des Auskoppelkegels liegen, mit hoher Wahrscheinlichkeit im Substrat durch Absorption verloren.

Der in der Praxis am häufigsten verwendete Weg, das geschilderte Problem zu mildern, besteht darin, eine dicke Halbleiter-Schicht an der Oberseite der LED aufzubringen. Dies ermöglicht die teilweise Nutzung der seitlichen Auskoppelkegel der emittierten Lichtstrahlung.

In der US 5,008,718 A wird vorgeschlagen, in einer AlGaInP-LED hauptsächlich aus Gründen der lateralen Verbreiterung des durch einen elektrischen Kontakt injizierten Stromes eine elektrisch leitfähige und für die emittierte Lichtstrahlung transparente GaP-Schicht auf den aktiven, lichtemittierenden Schichten aufzubringen. Auf den vorteilhaften Nebeneffekt der Verminderung der internen Totalreflexion und die Ermöglichung der seitlichen Auskopplung der Lichtstrahlung durch die Wirkung der dicken GaP-Schicht wird an anderer Stelle hingewiesen. Zusätzlich wird vorgeschlagen, das für die emittierte Lichtstrahlung undurchsichtige GaAs-Substrat durch Abätzen zu entfernen und durch mindestens eine transparente Substratschicht aus einem geeigneten Material, wie GaP, zu ersetzen.

Auch in der US 5,233,204 A wird die Verwendung einer oder mehrerer dicker und transparenter Schichten in einer Lichtemissionsdiode vorgeschlagen. Für die Anordnung und Anzahl dieser transparenten Schichten werden verschiedene Konfigurationen beschrieben. Unter anderem wird eine unterhalb der aktiven, lichterzeugenden Schicht angeordnete, sich in Richtung auf das Substrat verjüngende und trichterförmig gebildete Schicht vorgeschlagen.

Die bisher bekanntgewordenen Lösungsvarianten sind jedoch entweder technologisch relativ aufwendig oder erbringen nicht die erwünschte Steigerung der Lichtauskopplung aus einer Lichtemissionsdiode. Insbesondere das Aufwachsen einer relativ dicken, transparenten Halbleiterschicht ist bei der Herstellung von Lichtemissionsdioden ein relativ zeitaufwendiger Vorgang, da als Wachstumsverfahren zumeist entweder die metallorganische Gasphasenepitaxie (MOCVD) oder die Molekularstrahlepitaxie (MBE) eingesetzt werden. Bei diesen Wachstumsverfahren ist die Herstellung einer 10-20 $\mu$m dicken transparenten Halbleiterschicht ein zeitaufwendiger Prozeß, durch den die Gesamtdauer der Herstellung der Lichtemissionsdiode in nicht akzeptabler Weise verlängert wird.

Aus der DE 197 09 228 A1 ist bekannt, die Oberfläche eines Licht emittierenden Bauelements zu texturieren. Die Oberflächentexturierung weist eine Periodenlänge auf, die der Wellenlänge des ausgekoppelten Lichts enspricht. Dadurch wird der Sprung des Brechungsindex an der Oberfläche abgemildert und die Lichtauskoppelung aus dem Bauelement verbessert. Für die Texturierung der Oberfläche werden unter anderem kegelförmige Vorstände vorgeschlagen.

Aus der EP 0 544 512 A1 ist eine Lichtemissionsdiode bekannt, bei der eine dem Substrat gegenüber liegende Oberfläche derart strukturiert ist, dass sie eine Mehrzahl von Pyramidenstümpfen oder Kegelstümpfen aufweist.

Aus der DE 42 18 806 A1 ist ein Halbleiterelement in Mesa-Bauform bekannt, bei dem zur Verbesserung der Lichtausbeute in eine auf einem Substrat aufgebrachte Epitaxieschicht Vertiefungen eingebracht sind.

Aus der EP 0 405 757 A2 ist schließlich bekannt, Halbleiterchips mit guter Lichtausbeute kegelstumpfförmig auszubilden.

In der US 5,162,878 ist eine Totalreflexionsverhinderungsoberfläche beschrieben.

Es ist somit Aufgabe der vorliegenden Erfindung, eine Lichtemissionsdiode mit einer hohen effektiven Lichtauskopplung anzugeben, die ohne zusätzliche komplizierte oder zeitaufwendige Fertigungsschritte hergestellt werden kann.

Diese Aufgabe wird erfindungsgemäß mit den Merkmalen des Patentanspruchs 1 gelöst.

Demgemäß beschreibt die Erfindung eine Lichtemissionsdiode mit einer Halbleiterschichtstruktur enthaltend ein Substrat und mindestens eine auf dem Substrat geformte lichterzeugende Schicht, eine erste elektrische Kontaktschicht auf dem Substrat und eine zweite elektrische Kontaktschicht auf mindestens einem Abschnitt der dem Substrat gegenüberliegenden Oberfläche der Halbleiterschichtstruktur, wobei die dem Substrat gegenüberliegende Oberfläche auf mindestens einem Abschnitt derart strukturiert ist, daß sie außerhalb eines Bereichs der zweiten elektrischen Kontaktschicht eine Mehrzahl von Pyramidenstümpfen aufweist, wobei die Pyramidenstümpfe dreiseitig ausgeführt sein können. In den erfindungsgemäßen Pyramidenstümpfen wird ein Lichtstrahl durch Mehrfachreflexionen in einen Auskoppelkegel gelenkt. Zur Auskopplung werden nur Strahlen verwendet, die steil zur Oberseite der LED hin verlaufen. Dadurch werden lange Wege in der lichterzeugenden Schicht vermieden. Die schrägen Flanken der Pyramidenstümpfen gewährleisten, daß die zunächst steil nach oben verlaufenden Strahlen mit jeder der Reflexionen flacher verlaufen, so daß sie schließlich seitlich aus den Seitenwänden der Pyramidenstümpfe ausgekoppelt werden.

Vorzugsweise ist der mit der zweiten elektrischen Kontaktschicht bedeckte Abschnitt der lichtaustrittsseitigen Oberfläche unstrukturiert. In einer beispielhaften Ausführungsform ist bei einer quadratischen oder rechteckigen LED die zweite elektrische Kontaktschicht in Form einer Kreuzstruktur auf der lichtaustrittsseitigen Oberfläche aufgebracht. Diese Kreuzstruktur besteht aus einem im wesentlichen kreisförmigen Anschlußpad im Zentrum der rechteckförmigen lichtaustrittsseitigen Oberfläche und vom Kreisumfang in Richtung auf die vier Ecken des Chips verlaufenden fingerförmigen Anschlußflächen. Die zwischen diesen vier fingerförmigen Anschlußflächen liegenden Abschnitte sind jeweils mit einer Mehrzahl von Pyramidenstümpfen belegt, die derart angeordnet sind, daß eine möglichst große Anzahl aufgebracht werden kann.

Bezüglich der Form der Pyramidenstümpfen gibt es eine Mehrzahl von Parametern, die zu einer Optimierung der Auskopplung führen, wie bei sogenannten Raytracing-Simulationen ausführlich untersucht worden ist. Im folgenden werden optimierte Parameterbereiche für dreiseitige Pyramidenstümpfe angegeben. Wenn der Pyramidenstumpf eine Grundfläche A und eine Höhe h aufweist, so wird mit V das Verhältnis der Wurzel der Grundfläche zur Höhe des Pyramidenstumpfs beschrieben:

$$V \ = \ A^{1/2} \ / \ h$$

Ferner sind von Bedeutung die Anstellwinkel der drei Seitenflanken des Pyramidenstumpfes $\varphi$ und die Winkel $\alpha$, $\beta$ und $\gamma$ der dreieckigen Grundfläche.

Die besten Resultate werden nach den Raytracing-Simulationen mit den folgenden Parameterbereichen erreicht:

$$0,1 \ \leq \ V \ \leq \ 10$$

$$45° \ \leq \ \varphi \ \leq \ 88°$$

$$\alpha, \ \beta, \ \gamma \ > \ 10°$$

Besonders gute Werte für die Lichtauskopplung ergaben sich mit V = 1, $\varphi$ = 75° und einem gleichschenkligen Dreieck als Grundfläche, in dem der Winkel zwischen den beiden gleichen Schenkeln $\theta$ = 70° beträgt.

Die vorliegende Erfindung weist außerdem den Vorteil auf, daß sie auf einem nichtlokalen Auskoppelprinzip beruht, so daß technisch schwierig zu beherrschende Prozesse zur Stromeinschnürung entfallen. Weiterhin muß nur das obere Fenster strukturiert werden, während die aktive Zone nicht durchgeätzt und mithin nicht beschädigt wird. Die Struktur ist vergleichsweise einfach mit nur einem zusätzlichen lithographischen Prozeßschritt und nachfolgender Trockenätzung zu realisieren.

Im folgenden werden Ausführungsbeispiele der vorliegenden Erfindung anhand der Zeichnungen näher erläutert. Es zeigen:

Fig. 1    eine schematische, vereinfachte Querschnittsdarstellung der üblichen Anordnung einer LED in einem Reflektor;

Fig. 2    eine beispielhafte Form eines erfindungsgemäßen dreiseitigen Pyramidenstumpfes;

Fig. 3    eine Draufsicht auf eine rechteckförmige Oberfläche einer LED, die abschnittsweise mit erfindungsgemäßen Pyramidenstümpfen belegt ist.

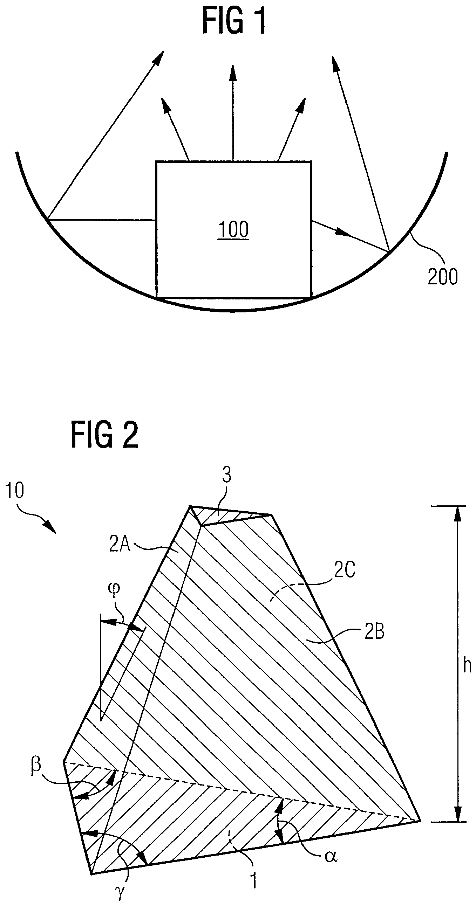

Die Fig. 1 zeigt einen LED-Chip 100, wie er in einem im Querschnitt kreis- oder parabelförmigen Reflektor 200 angeordnet ist, so daß die von ihm emittierten Lichtstrahlen sowohl auf direktem Wege abgestrahlt werden als auch durch den Reflektor 200 gesammelt und im wesentlichen in dieselbe Richtung emittiert werden. Im allgemeinen ist der LED-Chip 100 in einem Harzvergußmaterial eingebettet, so daß insbesondere an seiner lichtaustrittsseitigen Oberfläche eine Grenzfläche zwischen Halbleitermaterial und Harzvergußmaterial besteht. An dieser Grenzfläche existiert ein relativ großer Brechungsindexsprung, so daß bereits bei relativ geringen Einfallswinkeln zur Normalen eine Totalreflexion eintritt. Diese totalreflektierten Strahlen sollen nach Möglichkeit durch die Seitenwände des LED-Chips 100 ausgekoppelt werden und von dem Reflektor 200 gesammelt werden können, anstatt in dem Substrat des LED-Chips 100 absorbiert zu werden.

Eine erfindungsgemäße Lichtemissionsdiode weist eine Halbleiterschichtstruktur mit einem lichtabsorbierenden Substrat und mindestens einer auf dem Substrat geformten lichterzeugenden Schicht auf. Die lichterzeugende Schicht wird durch einen pn-Übergang gebildet. Falls gewünscht, kann eine Einfach- oder Mehrfach-Quantentrogstruktur als lichterzeugende Schicht vorgesehen sein. Die lichterzeugende Schicht befindet sich relativ nahe an der dem Substrat gegenüberliegenden lichtaustrittsseitigen Oberfläche der Halbleiterschichtstruktur. Auf dem Substrat ist eine erste elektrische Kontaktschicht ganzflächig aufgebracht, während auf mindestens einem Abschnitt der dem Substrat gegenüberliegenden Oberfläche der Halbleiterschichtstruktur eine zweite elektrische Kontaktschicht aufgebracht ist. In den nicht von der zweiten elektrischen Kontaktschicht belegten Abschnitten ist diese Oberfläche derart strukturiert, daß sie eine Mehrzahl von dreiseitigen Pyramidenstümpfen aufweist.

Ein derartiger Pyramidenstumpf 10 ist beispielhaft in Fig. 2 perspektivisch dargestellt. Er weist eine Grundfläche 1 auf, deren Flächeninhalt A beträgt und deren Winkel mit $\alpha$, $\beta$ und $\gamma$ bezeichnet werden. Diese Winkel sind betragsmäßig vorzugsweise jeweils größer als 10°. Beispielsweise kann ein gleichschenkliges Dreieck zum Einsatz kommen, bei welchem der Winkel zwischen den beiden gleichen Schenkeln $\theta$ ein Winkelmaß von 70° aufweist. Die Seitenwände 2A, B, C des Pyramidenstumpfes 10 weisen Anstellwinkel $\varphi$ auf, die vorzugsweise in einem Bereich zwischen 45° und 85° liegen. Der Pyramidenstumpf 10 verjüngt sich somit bis zu einer Fläche 3, die der Grundfläche 1 gegenüberliegt, wobei die Ebenen der Grundfläche 1 und der Fläche 3 zueinander parallel liegen.

In dem LED-Chip ist die dem Substrat gegenüberliegende Oberfläche auf mindestens einem Abschnitt mit Pyramidenstümpfen 10 der dargestellten Art bedeckt. Wie üblich kann der LED-Chip mit einem Epoxidharz-Material vergossen sein, so daß an den Seitenflanken 2A, B, C der Pyramidenstümpfe 10 ein Brechungsindexsprung zu dem umgebenden Harzmaterial auftritt. Lichtstrahlen, die von einem pn-Übergang unterhalb des Pyramidenstumpfes 10 durch seine Grundfläche 1 in den Pyramidenstumpf 10 eintreten, werden entweder an den Seitenflanken 2A, B, C totalreflektiert oder treten durch diese in das umgebende Harzmaterial ein und werden somit aus dem LED-Chip ausgekoppelt. Solche Lichtstrahlen, die in einem schrägen Winkel durch die Grundfläche 1 hindurchtreten, fallen relativ senkrecht auf die Seitenflanken 2A, B, C auf und treten somit direkt durch diese hindurch. Andere Lichtstrahlen wiederum, die durch die Grundfläche 1 senkrecht hindurchtreten, fallen unter einem relativ flachen Winkel auf die Seitenflanken 2A, B, C und werden daher an diesen totalreflektiert. Nach einer Reflexion trifft der Lichtstrahl jedoch auf die gegenüberliegende Seitenflanke. Mit jeder Reflexion wird infolge der Schrägstellung der Seitenflanken der Einfallswinkel des Lichtstrahls auf die jeweilige Seitenflanke kleiner, so daß es nach einer bestimmten Anzahl von Reflexionen zu einer seitlichen Auskopplung des Lichtstrahls aus dem Pyramidenstumpf 10 kommt. Die Durchführung sogenannter Raytracing Simulationen hat ergeben, daß eine optimierte Konfiguration der Parameter des Pyramidenstumpfes durch ein gleichschenkliges Dreieck als Grundfläche 1 mit einem Winkel zwischen den beiden gleichen Schenkeln $\theta = 70°$, Anstellwinkeln $\varphi = 75°$ und einer Höhe h des Pyramidenstumpfes 10 entsprechend der Wurzel des Flächenmaßes A der Grundfläche 1 gegeben ist.

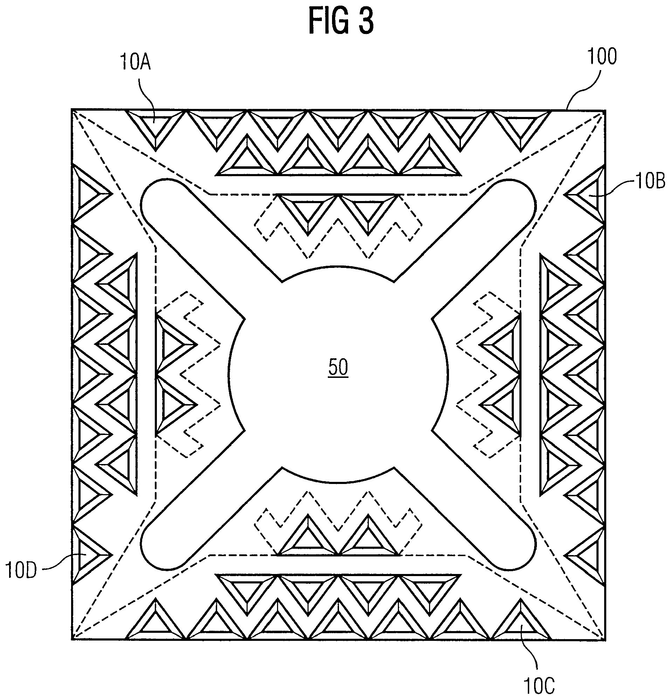

In Fig. 3 ist ein LED-Chip 100 in einer Draufsicht auf die dem Substrat gegenüberliegende Oberfläche dargestellt. Auf dem Substrat ist eine erste elektrische Kontaktschicht (nicht dargestellt) aufgebracht, während die in der Fig. 3 dargestellte Oberfläche mit einer zweiten elektrischen Kontaktschicht 50 versehen ist. Diese zweite elektrische Kontaktschicht 50 weist eine Kreuzstruktur mit einer zentralen kreisförmigen Kontaktfläche und von deren Umfang in Richtung auf die Ecken der rechteckförmigen Oberfläche ausgehenden fingerförmigen Kontaktflächen auf. Die zweite elektrische Kontaktschicht 50 kann durch eine undurchsichtige Metallschicht oder durch eine dünne, transparente Schicht, wie eine ITO (Indiumzinnoxid)-Schicht, gebildet sein. Zwischen den fingerförmigen Kontaktflächen der zweiten elektrischen Kontaktschicht 50 sind jedenfalls transparente Fensterbereiche gebildet, in denen jeweils Pyramidenstümpfe 10A-10D aufgebracht sind. In der Draufsicht ist von jedem der Pyramidenstümpfe die obere, kleinere Fläche und die untere Grundfläche zu sehen. Die Pyramidenstümpfe sind derart angeordnet, daß eine möglichst große Anzahl in jedem der fensterförmigen Bereiche angeordnet werden.

Wenn eine transparente Kontaktschicht 50 vorgesehen ist, so kann auch in dem Bereich der Kontaktschicht 50 eine Belegung mit Pyramidenstümpfen 10 vorgenommen werden.

Es können auch Pyramidenstümpfe mit vier oder mehr als vier Seiten verwendet werden. Auch der Grenzfall eines Kegelstumpfes, der eine kreisförmige Querschnittsfläche aufweist, soll von der vorliegenden Erfindung mitumfaßt sein.

**Patentansprüche**

1. Lichtemissionsdiode mit

    - einer Halbleiterschichtstruktur enthaltend ein Substrat und mindestens eine auf dem Substrat geformte lichterzeugende Schicht,
    - einer ersten elektrischen Kontaktschicht auf dem Substrat, und
    - einer zweiten elektrischen Kontaktschicht (50) auf mindestens einem Abschnitt der dem Substrat gegenüberliegenden Oberfläche der Halbleiterschichtstruktur, wobei
    - die dem Substrat gegenüberliegende Oberfläche der Halbleiterschichtstruktur auf mindestens einem Abschnitt derart strukturiert ist, daß sie außerhalb eines Bereichs der zweiten elektrischen Kontaktschicht (50) eine Mehrzahl von Pyramidenstümpfen oder Kegelstümpfen (10) aufweist, und wobei
- die Pyramidenstümpfe oder Kegelstümpfe so ausgebildet sind, dass ein Lichtstrahl in den Pyramidenstümpfen oder Kegelstümpfen durch Mehrfachreflexionen in einen Auskoppelkegel gelenkt wird.

2. Lichtemissionsdiode nach Anspruch 1,
**dadurch gekennzeichnet, daß**

- die Pyramidenstümpfe (10) dreiseitig sind.

3. Lichtemissionsdiode nach Anspruch 2,
**dadurch gekennzeichnet, daß**

- die dreiseitigen Pyramidenstümpfe (10) durch folgende Parameterbereiche definiert sind:

$$0,1 \leq V \leq 10$$

$$45° \leq \varphi \leq 88°$$

$$\alpha, \ \beta, \ \gamma \ > \ 10°$$

- wobei $V = A^{1/2} / h$ ist und A das Flächenmaß der dreieckigen Grundfläche (1) des Pyramidenstumpfes (10) und h die Höhe des Pyramidenstumpfes (10) ist, $\varphi$ die Anstellwinkel der Flanken der Pyramidenstümpfe (10) und $\alpha, \beta, \gamma$ die Winkel der dreieckigen Grundfläche (1) sind.

4. Lichtemissionsdiode nach Anspruch 3,
**dadurch gekennzeichnet, daß**

- V = 1, $\varphi$ = 75° für alle Seitenflanken (2A, 2B, 2C) und die Grundfläche (1) ein gleichschenkliges Dreieck mit dem Hauptwinkel $\theta$ = 70° ist.

5. Lichtemissionsdiode nach Anspruch 1,
**dadurch gekennzeichnet, daß**

- die Pyramidenstümpfe (10) vier oder mehr als vier Seiten aufweisen.

6. Lichtemissionsdiode nach einem der vorhergehenden Ansprüche,
**dadurch gekennzeichnet, daß**

- der mit der zweiten elektrischen Kontaktschicht (50) bedeckte Abschnitt der dem Substrat gegenüberliegenden Oberfläche unstrukturiert ist.

7. Lichtemissionsdiode nach einem der vorhergehenden Ansprüche,
**dadurch gekennzeichnet, daß**

- das Substrat aus GaAs gebildet ist und die lichterzeugende Schicht aus InGaAlP gebildet ist.

8. Lichtemissionsdiode nach einem der vorhergehenden Ansprüche,
**dadurch gekennzeichnet, daß**

- die dem Substrat gegenüberliegende Oberfläche rechteckförmig ist,
- die zweite elektrische Kontaktschicht (50) eine Kreuzstruktur mit einer zentralen Anschlußfläche und von dieser ausgehend, jeweils in Richtung auf die vier Ecken der rechteckförmigen Oberfläche verlaufenden fingerförmigen Anschlußflächen ist,
- die Bereiche (A-D) zwischen den fingerförmigen Anschlußflächen mit Pyramidenstümpfen (10) bedeckt sind.

9. Lichtemissionsdiode nach einem der vorhergehenden Ansprüche,
**dadurch gekennzeichnet, daß**

- die zweite elektrische Kontaktschicht (50) für die emittierte Lichtstrahlung undurchlässig ist.

10. Lichtemissionsdiode nach einem der vorhergehenden Ansprüche,
**dadurch gekennzeichnet, daß**

- die zweite elektrische Kontaktschicht (50) durch eine transparente, dünne, elektrisch leitfähige Schicht, insbesondere eine ITO (Indiumzinnoxid)-Schicht gebildet ist.

11. Lichtemissionsdiode nach Anspruch 10,
**dadurch gekennzeichnet, daß**

- die dem Substrat gegenüberliegende Oberfläche der Halbleiterschichtstruktur auch in dem Bereich der zweiten elektrischen Kontaktschicht Pyramidenstümpfe oder Kegelstümpfe aufweist.

**Claims**

1. Light-emission diode, comprising

- a semiconductor layer structure containing a substrate and at least one light-generating layer formed on the substrate,

- a first electrical contact layer on the substrate, and
- a second electrical contact layer (50) on at least one portion of the surface of the semiconductor layer structure opposite the substrate, wherein
- the surface of the semiconductor layer structure opposite the substrate is structured on at least one portion in such a way that it has a plurality of truncated pyramids or truncated cones (10) outside a region of the second contact layer, and wherein
- the truncated pyramids or truncated cones are formed such that a light beam in the truncated pyramids or truncated cones is directed in an out-coupling cone by multiple reflections.

2. Light-emission diode according to claim 1 **characterized in that**

   - the truncated pyramids (10) are three-sided.

3. Light-emission diode according to claim 2, **characterized in that**

   - the three-sided truncated pyramids (10) are defined by the following parameter ranges:

   $$0.1 \leq V \leq 10$$

   $$45° \leq \varphi \leq 88°$$

   $$\alpha, \beta, \gamma > 10°$$

   - wherein $V = A^{1/2} / h$ and A is the surface area of the triangular base surface (1) of the truncated pyramid (10) and h is the height of the truncated pyramid (10), $\varphi$ are the setting angles of the flanks of the truncated pyramids (10) and $\alpha, \beta, \gamma$ are the angles of the triangular base surface (1).

4. Light-emission diode according to claim 3, **characterized in that**

   - V = 1, $\varphi$ = 75° for all side flanks (2A, 2B, 2C) and the base surface (1) is an isosceles triangle having the main angle $\theta$ = 70°.

5. Light-emission diode according to claim 1, **characterized in that**

   - the truncated pyramids (10) have four or more than four sides.

6. Light-emission diode according to any of the preceding claims, **characterized in that**

   - the portion of the surface opposite the substrate, which is covered with the second electrical contact layer (50), is unstructured.

7. Light-emission diode according to any of the preceding claims, **characterized in that**

   - the substrate is formed from GaAs and the light-generating layer is formed from InGaAlP.

8. Light-emission diode according to any of the preceding claims, **characterized in that**

   - the surface of the semiconductor layer structure opposite the substrate is rectangular,
   - the second electrical contact layer (50) is a cross structure formed with a central connection area and, proceeding from the latter, finger-shaped connection areas extending therefrom, each in the direction of the four corners of the rectangular surface,
   - the regions (A-D) between the finger-shaped connection areas are covered with truncated pyramids (10) .

9. Light-emission diode according to any of the preceding claims, **characterized in that**

   - the second electrical contact layer (50) is non-transparent to the emitted light radiation.

10. Light-emission diode according to any of the preceding claims, **characterized in that**

   - the second electrical contact layer (50) is formed by a transparent, thin, electrically conductive layer, in particular an ITO (indium tin oxide) layer.

11. Light-emission diode according to claim 10, **characterized in that**

   - the surface of the semiconductor layer structure opposite the substrate comprises truncated pyramids or truncated cones also in the region of the second contact layer.

**Revendications**

1. Diode électroluminescente avec

   - une structure de couche semi-conductrice comprenant un substrat et au moins une couche génératrice de lumière formée sur le substrat,
   - une première couche de contact électrique sur le substrat et
   - une seconde couche de contact électrique (50) sur au moins une partie de la surface de la structure de couche semi-conductrice opposée au substrat,
   - la surface de la structure de couche semi-conductrice opposée au substrat étant structurée sur au moins une partie de telle sorte qu'elle présente une pluralité de pyramides ou cônes tronqués (10) à l'extérieur d'une région de la seconde couche de contact électrique (50) et
   - les pyramides ou cônes tronqués étant conçus de telle sorte qu'un faisceau lumineux dans les pyramides ou cônes tronqués est dirigé par des réflexions multiples dans un cône de découplage.

2. Diode électroluminescente selon la revendication 1, **caractérisée en ce que**

   - les pyramides tronquées (10) présentent trois côtés.

3. Diode électroluminescente selon la revendication 2, **caractérisée en ce que**

   - les pyramides tronquées à trois côtés (10) sont définies par les plages de paramètres suivantes :

$$0,1 \leq V \leq 10$$

$$45° \leq \varphi \leq 88°$$

$$\alpha, \beta, \gamma > 10°$$

   - $V = A^{1/2} / h$ et A étant la surface base (1) triangulaire de la pyramide tronquée (10) et h étant la hauteur de la pyramide tronquée (10), $\varphi$ correspondant aux angles d'incidence des flancs des pyramides tronquées (10) et $\alpha, \beta, \gamma$ correspondant aux angles de la surface base (1) triangulaire.

4. Diode électroluminescente selon la revendication 3, **caractérisée en ce que**

   - V = 1, $\varphi$ = 75° pour tous les flancs latéraux (2A, 2B, 2C) et la surface base (1) est un triangle isocèle avec l'angle principal $\theta$ = 70°.

5. Diode électroluminescente selon la revendication 1, **caractérisée en ce que**

   - les pyramides tronquées (10) présentent quatre côtés ou plus de quatre côtés.

6. Diode électroluminescente selon l'une des revendications précédentes, **caractérisée en ce que**

   - la partie de la surface opposée au substrat recouverte de la deuxième couche de contact électrique (50) n'est pas structurée.

7. Diode électroluminescente selon l'une des revendications précédentes, **caractérisée en ce que**

   - le substrat est formé de GaAs et la couche génératrice de lumière est formée de InGaAlP.

8. Diode électroluminescente selon l'une des revendications précédentes, **caractérisée en ce que**

   - la surface opposée au substrat est rectangulaire,
   - la deuxième couche de contact électrique (50) est une structure transversale avec dépôt conducteur central et partant de là, des dépôts conducteurs en forme de doigt s'étendant chacun en direction des quatre coins de la surface rectangulaire,
   - les zones (A-D) entre les dépôts conducteurs en forme de doigt sont recouvertes de pyramides tronquées (10).

9. Diode électroluminescente selon l'une des revendications précédentes, **caractérisée en ce que**

   - la seconde couche de contact électrique (50) est opaque au rayonnement lumineux émis.

10. Diode électroluminescente selon l'une des revendications précédentes, **caractérisée en ce que**

   - la deuxième couche de contact électrique (50) est formée par une couche transparente, mince et conductrice d'électricité, en particulier par une couche ITO (oxyde d'indium-étain).

11. Diode électroluminescente selon la revendication 10,

**caractérisée en ce que**

    - la surface de la structure de couche semi-conductrice opposée au substrat présente également des pyramides ou cônes tronqués dans la zone de la deuxième couche de contact électrique.

# FIG 1

100

200

# FIG 2

10

3

2A

φ

2C

2B

h

β

γ

α

1

# FIG 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5008718 A
- US 5233204 A
- DE 19709228 A1
- EP 0544512 A1
- DE 4218806 A1
- EP 0405757 A2
- US 5162878 A